(19) Europäisches Patentamt

European Patent Office

Office européen des brevets

(11) Veröffentlichungsnummer: **0 182 060 B1**

(12) **EUROPÄISCHE PATENTSCHRIFT**

(45) Veröffentlichungstag der Patentschrift: 20.02.91

(51) Int. Cl.5: **H05K 5/06**, H01B 17/26, H02G 3/08

(21) Anmeldenummer: 85112677.1

(22) Anmeldetag: 07.10.85

(54) Elektrisches Gerät, insbesondere für den Einsatz in schlagwettergefährdeter Umgebung.

(30) Priorität: 20.10.84 DE 3438522

(43) Veröffentlichungstag der Anmeldung:
28.05.86 Patentblatt 86/22

(45) Bekanntmachung des Hinweises auf die
Patenterteilung:
20.02.91 Patentblatt 91/08

(84) Benannte Vertragsstaaten:
AT BE CH DE FR GB IT LI LU NL SE

(56) Entgegenhaltungen:
US-A- 4 091 231

(73) Patentinhaber: Hamacher, Martin
Westerholter Strasse 791
D-4352 Herten / Westfalen(DE)

(72) Erfinder: Hamacher, Martin
Westerholter Strasse 791
D-4352 Herten / Westfalen(DE)

(74) Vertreter: Gesthuysen, Hans Dieter, Dipl.-Ing.
et al
Patentanwälte Gesthuysen + von Rohr
Huyssenallee 15 Postfach 10 13 33
D-4300 Essen 1(DE)

## Beschreibung

Die Erfindung betrifft ein elektrisches Gerät, insbesondere ein elektrisches Gerät für den Einsatz in schlagwettergefährdeter Umgebung, beispielsweise im untertägigen Bergbau, mit einem gefährdende, insbesondere schlagwettergefährdende elektrische Bauteile kapselnden Gehäuse, mindestens einer in einer Gehäusewand befestigten druckdichten Kabeldurchführung, einem in der Kabeldurchführung durch die Gehäusewand geführten Kabel und einem Druckgasanschluß, wobei im Inneren des Gehäuses über den Druckgasanschluß ein Gasüberdruck erzeugbar ist.

Elektrische Geräte für den Einsatz in explosionsgefährdeter, insbesondere in schlagwettergefährdeter Umgebung bedürfen einer besonderen Ausgestaltung für die gefährdenden, insbesondere die schlagwettergefährdenden elektrischen Bauteile. Wesentlich ist dabei, daß ein eventuell in einem solchen elektrischen Gerät entstehender Zündfunke nicht zu einer Explosion außerhalb des elektrischen Gerätes befindlicher explosiver Gase führen darf. Ohne daß dies als Einschränkung des Schutzumfanges zu verstehen ist, sollen der Ausgangspunkt für die Erfindung und die Erfindung selbst anhand eines elektrischen Gerätes für den Einsatz in schlagwettergefährdeter Umgebung erläutert werden.

Elektrische Geräte für den Einsatz in schlagwettergefährdeter Umgebung können nach unterschiedlichen Schutzarten schlagwettergeschützt sein. Besonders verbreitet ist bislang die Schutzart "druckfeste Kapselung", bei der die gefährdenden elektrischen Bauteile in ein Gehäuse eingeschlossen sind, das bei einer eventuell im Inneren des Gehäuses auftretenden Explosion den dabei entstehender Druck aushält und eine Übertragung einer solchen Explosion nach außen verhindert. Weitere Schutzarten sind die "Plattenschutzkapselung", die "Ölkapselung" und die "Fremdbelüftung". Seit jüngerer Zeit ist auch die Schutzart "Überdruckkapselung" bekannt, bei der die schlagwettergefährdenden elektrischen Bauteile im ein Gehäuse eingeschlossen sind, in dessen Innerem ein Gasüberdruck herrscht. Das im Inneren eines solchen Gehäuses unter Überdruck stehende Gas ist meist Luft oder ein Inertgas, beispielsweise Stickstoff.

Die neuere Schutzart "Überdruckkapselung" hat gegenüber der Schutzart "druckfeste Kapselung" den Vorteil, daß wegen des im Inneren des Gehäuses herrschenden Überdrucks explosive Gase gar nicht erst in das Innere des Gehäuses eintreten können. Bei der Schutzart "Überdruckkapselung" wird also systemgemäß verhindert, daß überhaupt explosive Gase in das Innere des Gehäuses eintreten und mit einem eventuell dort entstehenden Zündfunken in Berührung kommen können. Dementsprechend kann das Gehäuse sogar weniger massiv ausgeführt sein als bei der Schutzart "druckfeste Kapselung", zumindest ist gegenüber der Schutzart "druckfeste Kapselung" ein nochmals verbesserter Schlagwetterschutz gewährleistet.

Auch bei der sorgfältigsten Abdichtung ist nicht zu verhindern, daß der Gasüberdruck im Inneren des Gehäuses eines elektrischen Gerätes der Schutzart "Überdruckkapselung" im Laufe der Zeit absinkt. Zusätzlich zu dem anfänglichen Erzeugen des Gasüberdruckes im Inneren des Gehäuses muß also von Zeit zu Zeit Gas nachgepumpt werden. Dazu dient ein in der Gehäusewand angeordneter Druckgasanschluß, der üblicherweise mit einem selbstschließenden Ventil, beispielsweise einem Rückschlagventil versehen ist. Zweckmäßigerweise ist überdies im Inneren eines solchen elektrischen Gerätes noch ein Drucksensor vorgesehen, der mit einer entweder außen am Gehäuse des elektrischen Gerätes oder entfernt in einer Bedienungswarte vorgesehenen Druckanzeige zusammenwirkt. Dadurch ist eine Überwachung des im Inneren des Gehäuses des elektrischen Gerätes existierenden Gasüberdruckes gewährleistet und es muß Druckgas nur nachgepumpt werden, wenn dies wirklich notwendig ist.

Die voranstehenden Erläuterungen haben gezeigt, daß ein elektrisches Gerät der Schutzart "Überdruckkapselung" gehäuseseitig einer speziellen, herstellungstechnisch und anwendungstechnisch aufwendigen Ausgestaltung bedarf, nämlich mit einem eigenen Druckgasanschluß versehen werden muß. Das erschwert insbesondere die Umrüstung vorhandener elektrischer Geräte der Schutzart "druckfeste Kapselung" zu Geräten der Schutzart "Überdruckkapselung". Der Erfindung liegt daher die Aufgabe zugrunde anzugeben, wie bei einem elektrischen Gerät der in Rede stehenden Art der Druckgasanschluß herstellungstechnisch und anwendungstechnisch besonders einfach, insbesondere einfach nachrüstbar, gestaltet werden kann.

Das erfindungsgemäße elektrische Gerät, bei dem die zuvor aufgezeigte Aufgabe gelöst ist, ist dadurch gekennzeichnet, daß der Druckgasanschluß in das in der Kabeldurchführung geführte Kabel oder in die Kabeldurchführung als solche integriert ist. Erfindungsgemäß ist erkannt worden, daß ein elektrisches Gerät der in Rede stehenden Art zwingend mindestens eine in einer Gehäusewand befestigte Kabeldurchführung mit einem darin geführten Kabel aufweist. Erfindungsgemäß wird dieses ohnehin vorhandene Kabel bzw. diese ohnehin vorhandene Kabeldurchführung dazu genutzt, den Druckgasanschluß vorzusehen. Das ist für die Neuherstellung elektrischer Geräte der in Rede stehenden Art sehr zweckmäßig, da die Gehäusewand des Gehäuses nur für die Kabeldurchführung durchbrochen zu werden braucht, d. h. kein gesonderter, wiederum Abdichtungsprobleme aufwerfender Druckgasanschluß vorgesehen werden muß. Von besonderer Bedeutung ist die Erfindung aber auch bei der Nachrüstung eines Druckgasanschlusses bei vorhandenen elektrischen Geräten der in Rede stehenden Art. Dort kann der ohnehin vorhandene Durchbruch für die Kabeldurchführung erfindungsgemäß eben auch für den Druckgasanschluß genutzt werden.

Die Lehre der Erfindung läßt sich generell bei allen elektrischen Geräten verwirklichen, bei denen im Inneren des Gehäuses über den Druckgasanschluß ein Gasüberdruck erzeugt werden soll, sie ist jedoch für elektrische Geräte für den Einsatz in schlagwettergefährdeter Umgebung in der Schutzart "Überdruckkapselung" von hervorragender Bedeutung.

Es gibt nun verschiedene Möglichkeiten, die Lehre der Erfindung auszugestalten und weiterzubilden. Beispielhaft sollen Ausgestaltungen und Weiterbildungen anhand der lediglich Ausführungsbeispiele darstellenden Zeichnung erläutert werden. Es zeigt

Fig. 1    in Seitenansicht und in schematischer Darstellung ein erstes Ausführungsbeispiel eines erfindungsgemäßen elektrischen Gerätes mit einem in einer Kabeldurchführung durch die Gehäusewand geführten Kabel,

Fig. 2    einen Schnitt durch das Kabel aus Fig. 1 entlang der Linie II - II,

Fig. 3    einen Fig. 2 entsprechenden Schnitt für ein anderes Ausführungsbeispiel eines Kabels für ein elektrisches Gerät gemäß Fig. 1,

Fig. 4    in Fig. 1 entsprechender Darstellung ein zweites Ausführungsbeispiel eines erfindungsgemäßen elektrischen Gerätes,

Fig. 5    das Ausführungsbeispiel aus Fig. 4 in einer Ansicht in Richtung des Pfeils V und

Fig. 6    in Fig. 1 entsprechender Darstellung ein drittes Ausführungsbeispiel eines erfindungsgemäßen elektrischen Gerätes.

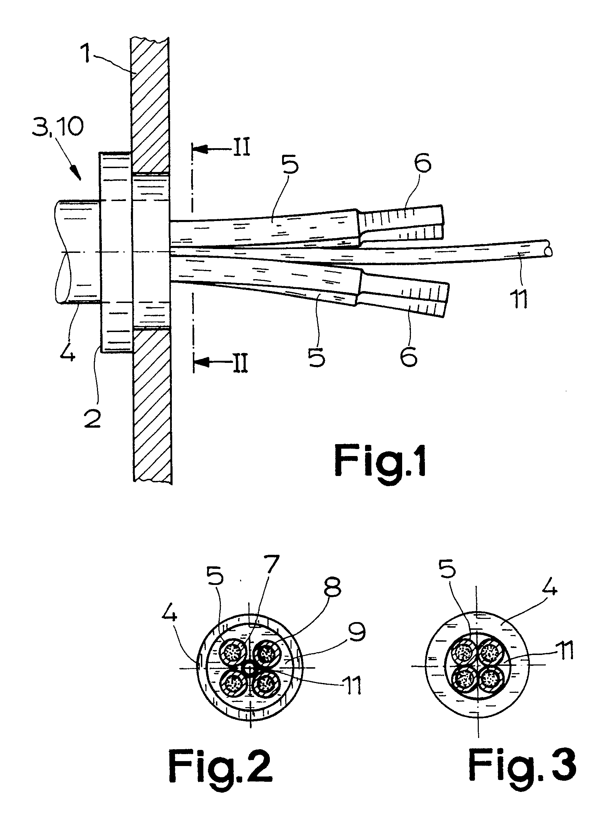

Fig. 1 zeigt lediglich schematisch und ausschnittweise ein elektrisches Gerät für den Einsatz in schlagwettergefährdeter Umgebung mit einem schlagwettergefährdende elektrische Bauteile kapselnden Gehäuse, von dem nur eine Gehäusewand 1 im Schnitt dargestellt ist. In der Gehäusewand 1 ist eine druckdichte Kabeldurchführung 2 befestigt, wie sie beispielsweise aus der DE-PS 25 39 456 bekannt ist. In der Kabeldurchführung 2 ist durch die Gehäusewand 1 ein Kabel 3 durchdicht geführt. Dieses Kabel 3 weist, soweit in Fig. 1 erkennbar, einen Außenmantel 4 aus einem isolierenden Kunststoff und vier Adern 5 auf. Die Adern 5 des Kabels 3 bestehen ihrerseits in der üblichen Weise aus einer Aderisolierung und einer Leiterseele. Von den Leiterseelen der Adern 5 sind jeweils die Endstücke 6 in Fig. 1 zu erkennen.

Fig. 2 zeigt in Verbindung mit Fig. 1 noch etwas deutlicher den Aufbau des Kabels 3 aus Fig. 1. Deutlich zu erkennen sind zunächst der aus isolierendem Kunststoff bestehende Außenmantel 4 und die Adern 5. Gut zu erkennen sind aber auch die Aderisolierungen 7 und Leiterseelen 8 der einzelnen Adern 5. Außerdem ist deutlich erkennbar, daß zusätzlich zum Außenmantel 4 ein die Adern 5 umhüllender und die Zwischenräume zwischen den Adern 5 ausfüllender Ausfüllmantel 9 aus hochflexiblem isolierendem Kunststoff vorgesehen ist. Die Adern 5 sind in diesen Ausfüllmantel 9 regelrecht eingebettet.

Bei dem in Rede stehenden elektrischen Gerät für den Einsatz in schlagwettergefährdeter Umgebung handelt es sich um ein elektrisches Gerät der Schutzart "Überdruckkapselung", also um ein elektrisches Gerät, bei dem im Inneren des Gehäuses ein Gasüberdruck vorhanden sein und aufrechterhalten werden muß. Als Druckgas im Inneren des Gehäuses eines solchen elektrischen Gerätes kommt Luft oder ein Inertgasm, beispielsweise Stickstoff, in Frage. Zur Erzeugung des Gasüberdruckes im Inneren des Gehäuses und zum Nachpumpen von Druckgas ist ein Druckgasanschluß 10 vorgesehen.

Bei dem in Fig. 1 dargestellten ersten Ausführungsbeispiel der Erfindung ist nun der Druckgasanschluß 10 in das in der Kabeldurchführung 2 geführte Kabel 3 integriert. Fig. 2 läßt in Verbindung mit Fig. 1 deutlich erkennen, daß im hier dargestellten Ausführungsbeispiel für den Druckgasanschluß 10 eine Druckgasleitung 11 als eine weitere Ader 5 des Kabels 3 vorgesehen ist. Das in Fig. 1 dargestellte Ausführungsbeispiel läßt erkennen, daß die Druckgasleitung 11 im wesentlichen ein Kunststoffschlauch ist, der mit dem Kabel 3 zu einem vom elektrischen Gerät entfernten Anschlußort läuft. In Fig. 1 ist nicht dargestellt, wo und wie die Druckgasleitung 11 im Inneren des elektrischen Gerätes angeschlossen ist. In bekannter Weise kann jedenfalls hier der Druckgasleitung 11 ein Ventil, beispielsweise ein selbsttätig arbeitendes Absperrventil zugeordnet sein. Wesentlich für die Erfindung ist jedenfalls, daß diese Druckgasleitung 11 durch die Gehäusewand 1 des Gehäuses des elektrischen Gerätes hindurchgeführt ist, ohne daß es eines besonderen Durchbruches durch die Gehäusewand 1 bedurft hätte.

Betrachtet man nun Fig. 3 der Zeichnung in Verbindung mit Fig. 1, so wird der Unterschied des hier dargestellten Ausführungsbeispiels eines Kabels 3 zu dem in Fig. 2 dargestellten Ausführungsbeispiel eines Kabels 3 deutlich. Wesentlich ist hier, daß das Kabel 3 nur den Außenmantel 4 aus isolierenden Kunststoff und die Adern 5 aufweist, nicht aber den in Fig. 2 noch erkennbaren Ausfüllmantel 9. Die Zwischenräume zwischen den Adern 5 sind hier nicht ausgefüllt (sie könnten auch ggf. nur zum Teil ausgefüllt sein) und dienen als Druckgasleitung 11. Das Druckgas strömt hier also praktisch im Inneren des Außenmantels 4 parallel zu den Adern 5 und tritt ohne weiteres in das Innere des Gehäuses ein. Auch hier führt eine Betrachtung von Fig. 1 in Verbindung mit Fig. 3 zu dem Eindruck, daß die so gebildete Druckgasleitung 11 sich auch hier gemeinsam mit dem Kabel 3 zu einem entfernten Anschlußort hin erstreckt. Wie bei dem zuvor erläuterten Ausführungsbeispiel muß natürlich an dem entsprechenden Anschlußort dafür gesorgt werden, daß die tatsächlich (Fig. 2) oder gewissermaßen virtuell (Fig. 3) vorhandene Druckgasleitung 11 an eine Druckgasquelle angeschlossen bzw. anschließbar ist.

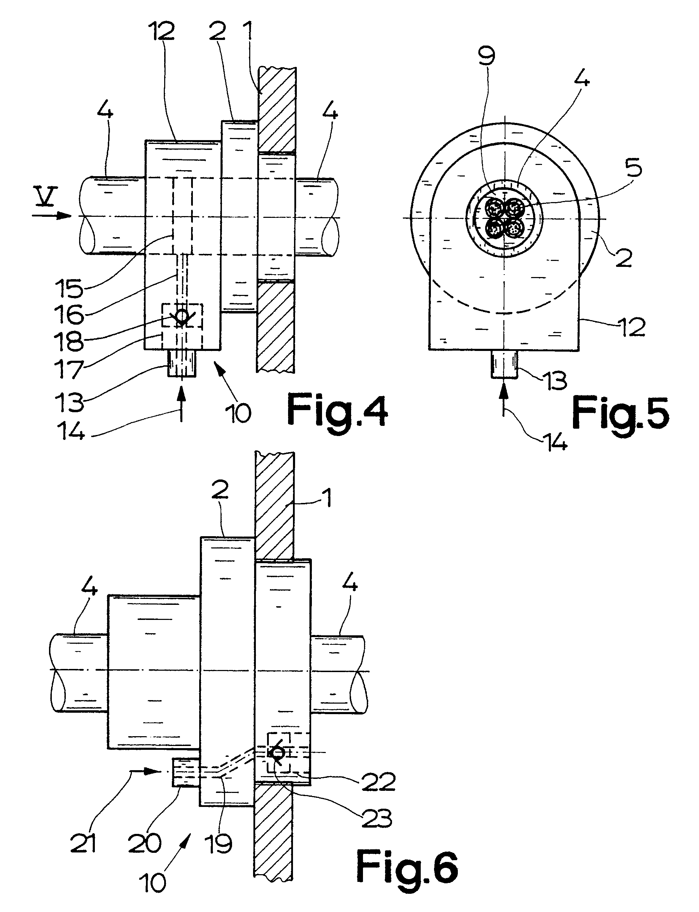

Es ist allerdings nicht zwingend, daß die Druckgasleitung 11 sich gemeinsam mit dem Kabel 3 zu einem entfernten Anschlußort hin erstreckt. Es ist durchaus auch möglich, die Druckgasleitung 11 unmittelbar am elektrischen Gerät auf der Außenseite aus dem Kabel 3 herauszuführen. Eine hierzu zweckmäßige Ausgestaltung des erfindungsgemäßen elektrischen Gerätes ist dadurch gekennzeichnet, daß die Kabeldurchführung 2 auf der Außenseite mit einem Druckgasanschlußteil 12 versehen ist und daß das Druckgasanschlußteil 12 mit einem Anschlußstück 13 für eine externe Druckgasleitung 14 versehen ist. Das ist in den Fig. 4 und 5 der Zeichnung deutlich erkennbar dargestellt. Die mit dem Anschlußstück 13 des Druckgasanschlußteils 12 zu verbindende externe Druckgasleitung 14 ist lediglich durch einen Pfeil angedeutet. Ist die Druckgasleitung 11 im Kabel 3 körperlich vorhanden, so ist diese zweckmäßigerweise im Druckgasanschlußteil 12 aus dem Kabel 3 herausgeführt und zum Anschlußstück 13 hingeführt.

Fig. 4 zeigt eine Ausgestaltung der Erfindung für eine Druckgasleitung 11 die lediglich "virtuell" vorhanden ist, wie das in Verbindung mit Fig. 3 erläutert worden ist. Hierzu weist das Druckgasanschlußteil 12 einen den Außenmantel 4 des Kabels 3 auf einem kurzen Stück der Länge des Kabels 3 ersetzenden, mit einem umlaufenden Kanal versehenen Ring 15 auf, der mittels eines Druckgaskanals 16 mit dem Anschlußstück 13 verbunden ist. Die Zwischenräume zwischen den Adern 5 des Kabels 3 sind auf der Innenseite des Druckgasanschlußteils 12 natürlich nicht oder nur zum Teil ausgefüllt, um so die in das Innere des Gehäuses des elektrischen Gerätes führende Druckgasleitung 11 zu bilden, diese Zwischenräume sind aber auf der Außenseite des Druckgasanschlußteils 12 druckdicht ausgefüllt, beispielsweise durch den in Verbindung mit Fig. 2 schon erläuterten Ausfüllmantel 9 aus hochflexiblem isolierendem Kunststoff. Damit ist eine recht elegante Möglichkeit gegeben, das Druckgas vom Anschlußstück 13 in die Zwischenräume zwischen den Adern 5 des Kabels 3 und in das Innere des Gehäuses einzubringen.

Bei der zuletzt erläuterten Ausführungsform eines erfindungsgemäßen elektrischen Gerätes ist es zweckmäßig, wenn das Druckgasanschlußteil 12 ein einsteckbares oder einschraubbares, vorzugsweise das Anschlußstück 13 tragendes Einsatzstück 17 aufweist. Das Druckgasanschlußteil 12 kann überdies auch noch mit einem Rückschlagventil 18 für die Druckgasleitung 11 bzw. den Druckgaskanal 16 versehen sein. Fig. 4 zeigt insoweit ein besonders bevorzugtes Ausführungsbeispiel eines erfindungsgemäßen elektrischen Gerätes als nämlich das Rückschlagventil 18 hier Teil des Einsatzstückes 17 bzw. vom Einsatzstück 17 gehalten ist.

Die voranstehenden Erläuterungen bevorzugter Ausführungsbeispiele der Erfindung befassen sich in erste Linie mit der ersten Alternative der Lehre, wonach der Druckgasanschluß 10 in das in der Kabeldurchführung 2 geführte Kabel 3 integriert ist. Der Druckgasanschluß 10 kann aber ebensogut auch in die Kabeldurchführung 2 als solche integriert sein. Fig. 6 zeigt dazu ein besonders bevorzugtes Ausführungsbeispiel, bei dem die Kabeldurchführung 2 einen im wesentlichen parallel zu dem für die Durchführung des Kabels 3 dienenden Kanal angeordneten Druckgaskanal 19 mit einer Mündung an der Außenseite und einer Mündung an der Innenseite der Kabeldurchführung 2 aufweist. Im hier dargestellten bevorzugten Ausführungsbeispiel ist der Druckgaskanal 19 an seiner an der Außenseite der Kabeldurchführung 2 angeordneten Mündung mit einem Anschlußstück 20 zum Anschluß einer externen Druckgasleitung 21 versehen. Die externe Druckgasleitung 21 ist hier nur durch einen Pfeil angedeutet.

Im dargestellten Ausführungsbeispiel ist die an der Innenseite der Kabeldurchführung 2 angeordnete Mündung des Druckgaskanals 19 in einem in den Körper der Kabeldurchführung 2 einsteckbarem oder einschraubbarem Einsatzstück 22 ausgebildet. Außerdem ist in den Druckgaskanal 19 ein Rückschlagventil 23 integriert. Dieses Rückschlagventil 23 ist hier Teil des Einsatzstückes 22 bzw. wird von dem Einsatzstück 22 in der entsprechenden Ausnehmung im Körper der Kabeldurchführung 2 gehalten.

In allen Figuren ist die Kabeldurchführung 2 in die Gehäusewand 1 einschraubbar. Aufgrund des parallel zum für die Durchführung des Kabels 3 dienenden Kanal angeordneten Druckgaskanals 19 beim Ausführungsbeispiel aus Fig. 6 ist der Durchmesser dieser Kabeldurchführung 2 natürlich erheblich größer als der Durchmesser der Kabeldurchführungen gemäß Fig. 1 und Fig. 4. Der Durchbruch in der Gehäusewand 1 muß also einen größeren Durchmesser aufweisen. Das mag für eine Nachrüstung ein Nachteil sein. Vorteilhaft ist aber bei dieser Ausgestaltung eines erfindungsgemäßen elektrischen Gerätes, daß die Einbringung des Druckgases ins Innere des Gehäuses konstruktiv recht einfach ist.

Die in den voranstehenden Erläuterungen immer behandelten Rückschlagventile 18, 23 sind Ventile, die einen Abbau des im Inneren des Gehäuses vorhandenen Gasüberdruckes verhindern. Für den Fall, daß aufgrund unvorhergesehener Ereignisse außerhalb des Gehäuses der Druck der Umgebungsatmosphäre so stark ansteigt, daß er größer wird als der Gasüberdruck im Inneren des Gehäuses, sollte ein ungewolltes Eintreten von Gas in das Innere des Gehäuses vermieden werden. Hierzu geht eine weitere Lehre der Erfindung dahin, daß der Druckgasanschluß mit einem bei Anschluß einer externen Druckgasleitung vorzugsweise automatisch öffenbaren Schutzventil versehen ist. Dies ist in den Figuren im einzelnen nicht weiter dargestellt.

Weiter oben ist erläutert worden, daß die Überwachung des Gasüberdruckes im Inneren des Gehäuses eines elektrischen Gerätes der in Rede stehenden Art zweckmäßig ist. Im Rahmen der Erfindung liegt es, das elektrische Gerät so auszugestalten, daß die Kabeldurchführung auf der Innenseite einen Drucksensor und ggf. auf der Außenseite eine Druckanzeige aufweist. Damit ist eine vollständige Integration beim erfindungsgemäßen elektrischen Gerät erzielbar, so daß insbesondere eine außerordentlich einfache Nachrüstbarkeit eines elektrischen Gerätes der Schutzart "druckfeste Kapselung" zur Schutzart "Überdruckkapselung" gewährleistet ist.

## Ansprüche

1. Elektrisches Gerät, insbesondere für den Einsatz in schlagwettergefährdeter Umgebung, mit einem gefährdende, insbesondere schlagwettergefährdende elektrische Bauteile kapselnden Gehäuse, mindestens einer in einer Gehäusewand befestigten, druckdichten Kabeldurchführung, einem in der Kabeldurchführung durch die Gehäusewand geführten Kabel und einem Druckgasanschluß, wobei im Inneren des Gehäuses über den Druckgasanschluß ein Gasüberdruck erzeugbar ist, **dadurch gekennzeichnet,** daß der Druckgasanschluß (10) in das in der Kabeldurchführung (2) geführte Kabel (3) oder in die Kabeldurchführung (2) als solche integriert ist.

2. Elektrisches Gerät nach Anspruch 1, wobei das Kabel mehrere Adern, ggf. einen die Adern umhüllenden und die Zwischenräume zwischen den Adern ausfüllenden Ausfüllmantel und einen Außenmantel aufweist, dadurch gekennzeichnet, daß als eine (weitere) Ader (5) des Kabels (3) eine Druckgasleitung (11) vorgesehen ist.

3. Elektrisches Gerät nach Anspruch 1, wobei das Kabel mehrere Adern und einen Außenmantel aufweist, dadurch gekennzeichnet, daß die Zwischenräume zwischen den Adern (5) nicht oder nur zum Teil ausgefüllt sind und die nicht ausgefüllten Zwischenräume als Druckgasleitung (11) dienen.

4. Elektrisches Gerät nach einem der Ansprüche 1 bis 3, dadurch gekennzeichnet, daß die Kabeldurchführung (2) auf der Außenseite mit einem Druckgasanschlußteil (12) versehen ist und daß das Druckgasanschlußteil (12) mit einem Anschlußstück (13) für eine externe Druckgasleitung (14) versehen ist.

5. Elektrisches Gerät nach den Ansprüchen 2 und 4, dadurch gekennzeichnet, daß im Druckgasanschlußteil (12) die Druckgasleitung (11) aus dem Kabel (3) heraus und zum Anschlußstück (13) hin geführt ist.

6. Elektrisches Gerät nach den Ansprüchen 3 und 4, dadurch gekennzeichnet, daß das Druckgasanschlußteil (12) einen den Außenmantel (4) des Kabels (3) auf einem kurzen Stück der Länge des Kabels (3) ersetzenden, mit einem umlaufenden Kanal versehenen Ring (15) aufweist, daß der Ring (15) mittels eines Druckgaskanals (16) mit dem Anschlußstück (13) verbunden ist und daß die Zwischenräume zwischen den Adern (5) des Kabels (3) auf der Außenseite des Druckgasanschlußteils (12) druckdicht ausgefüllt sind.

7. Elektrisches Gerät nach einem der Ansprüche 4 bis 6, dadurch gekennzeichnet, daß das Druckgasanschlußteil (12) ein einsteckbares oder einschraubbares, vorzugsweise das Anschlußstück (13) tragendes Einsatzstück (17) aufweist.

8. Elektrisches Gerät nach einem der Ansprüche 4 bis 7, dadurch gekennzeichnet, daß im Druckgasanschlußteil (12) ein Rückschlagventil (18) für die Druckgasleitung (11) bzw. den Druckgaskanal (16) vorgesehen ist.

9. Elektrisches Gerät nach den Ansprüchen 7 und 8, dadurch gekennzeichnet, daß das Rückschlagventil (18) Teil des Einsatzstückes (17) ist.

10. Elektrisches Gerät nach Anspruch 1, dadurch gekennzeichnet, daß die Kabeldurchführung (2) einen im wesentlichen parallel zu dem für die Durchführung des Kabels (3) dienenden Kanal angeordneten Druckgaskanal (19) mit einer Mündung an der Außenseite und einer Mündung an der Innenseite der Kabeldurchführung (2) aufweist.

11. Elektrisches Gerät nach Anspruch 10, dadurch gekennzeichnet, daß der Druckgaskanal (19) an seiner an der Außenseite der Kabeldurchführung (2) angeordneten Mündung mit einem Anschlußstück (20) zum Anschluß einer externen Druckgasleitung (21) versehen ist.

12. Elektrisches Gerät nach Anspruch 10 oder 11, dadurch gekennzeichnet, daß die an der Innenseite der Kabeldurchführung (2) angeordnete Mündung und/oder die an der Außenseite der Kabeldurchführung (2) angeordnete Mündung des Druckgaskanals (19) in einem in den Körper der Kabeldurchführung (2) einsteckbarem oder einschraubbarem Einsatzstück (22) ausgebildet ist.

13. Elektrisches Gerät nach einem der Ansprüche 10 bis 12, dadurch gekennzeichnet, daß in den Druckgaskanal (19) ein Rückschlagventil (23) integriert ist.

14. Elektrisches Gerät nach den Ansprüchen 12 und 13, dadurch gekennzeichnet,daß das Rückschlagventil (23) Teil des Einsatzstückes (22) ist.

15. Elektrisches Gerät nach einem der Ansprüche 1 bis 14, dadurch gekennzeichnet, daß der Druckgasanschluß mit einem bei Anschluß einer externen Druckgasleitung vorzugsweise automatisch öffenbaren Schutzventil versehen ist.

16. Elektrisches Gerät nach einem der Ansprüche 1 bis 15, dadurch gekennzeichnet, daß die Kabeldurchführung auf der Innenseite einen Drucksensor und ggf. auf der Außenseite eine Druckanzeige aufweist.

**Claims**

1. An electrical equipment, particularly for use in surroundings endangered by explosive atmospheres, with a housing encasing endangered electrical components particularly those endangered by explosive atmospheres, with at least one pressure-tight cable entry fastened into a housing wall, with a cable led through the housing wall in the cable entry and with a compressed gas connection in which a positive gas pressure is produceable within the housing via the compressed gas connection. characterized in that the compressed gas connection (10) is an integral part of the cable (3) led through the cable entry (2) or of the cable entry (2) itself.

2. An electrical equipment according to Claim 1, in which the cable possesses several cores, possibly a filler sheathing surrounding the cores and filling up the interstices between them, and an outer sheathing, characterized in that a compressed gas duct (11) is provided as a [further] core '5) of the cable (3).

3. An electrical equipment according to Claim 1, in which the cable possesses several cores and an outer sheathing characterized in that the interstices between the cores (5) are unfilled or are only partially filled and the unfilled interstices serve as a compressed gas duct (11).

4. An electrical equipment according to one of Claims 1 to 3. characterized in that the cable entry (2) is provided on the outside with a compressed gas connector (12) and that the compressed gas connector (12) is provided with a connection piece (l3) for an external compressed gas pipe (14).

5. An electrical equipment according to Claims 2 and 4, characterized in that the compressed gas duct (11) is led out of cable (3) into compressed gas connector (12) and is led into connection piece (13).

6. An electrical equipment according to Claims 3 and 4, characterized in that the compressed gas connector (12) possesses a ring (15) that replaces the outer sheathing (4) of cable (3) for a short portion of the length of cable (3) and is provided with a peripheral channel. that the ring (15) is connected to connection piece (13) by means of a compressed gas channel (16), and that the interstices between the cores (5) of cable (3) are packed pressure-tight on the outer side of the compressed gas connector (12).

7. An electrical equipment according to one of Claims 4 to 6, characterized in that the compressed gas connector (12) possesses an insert (17) that can be plugged or screwed in and preferably carries the connection piece (13)

8. An electrical equipment according to one of Claims 4 to 7 characterized in that a non-return valve (18) is provided in the compressed gas connector (12) for the compressed gas duct (11) or the compressed gas channel (16).

9. An electrical equipment according to Claims 7 and 8. characterized in that the non-return valve (18) forms part of the insert (17).

10. An electrical equipment according to Claim 1, characterized in that the cable entry (2) possesses a compressed gas channel (19), arranged approximately parallel to the channel serving for the passage of cable (3), with an orifice on the outer face and an orifice on the inner face of cable entry (2).

11. An electrical equipment according to Claim 10. characterized in that the compressed gas channel (19) is provided at its orifice located on the outer face of cable entry (2), with a connection piece (20) for the connection of an external compressed gas pipe (21).

12. An electrical equipment according to Claim 10 or 11, characterized in that the orifice of the compressed gas channel (19) located on the inner face of cable entry (2) and/or the orifice of the compressed gas channel (19) located on the outer face of cable entry (2) is formed into an insert (22) that can be plugged or screwed into the body of cable entry (2).

13. An electrical equipment according to one of Claims 10 to 12, characterized in that a non-return valve (23) is made an integral part of the compressed gas channel (19).

14. An electrical equipment according to Claims 12 and 13, characterized in that the non-return valve (23) is a part of the insert (22).

15. An electrical equipment according to one of Claims 1 to 14, characterized in that the compressed gas connection is provided with a safety valve that can be opened preferably automatically, on the connection of an external compressed gas pipe.

16. An electrical equipment according to one of Claims 1 to 15, characterized in that the cable entry has an internal pressure sensor and possibly an external pressure indicator.

**Revendications**

1. Dispositif électrique, plus particulièrement pour l'application dans une ambiance grisouteuse, avec un carter enveloppant des composants électriques menacés, surtout menacés par le grisou, avec au moins une entrée de câble étanche à la pression, montée dans une paroi du carter, un câble introduit dans l'entrée de câble à travers la paroi du carter et un raccordement pour l'admission du gaz sous pression, où à l'intérieur du carter une surpression de gaz peut être provoquée par le raccordement pour l'admission du gaz sous pression, caractérisé en ce que le raccordement pour l'admission du gaz sous pression (10) est intégré dans le câble (3) introduit dans l'entrée de câble (2) ou dans l'entrée de câble (2) tel quel.

2. Dispositif électrique suivant la revendication 1, où le câble comporte plusieurs fils conducteurs, au besoin une gaine de rembourrage, enveloppant les fils conducteurs et rembourrant les espaces entre les fils conducteurs et une gaine extérieure, caractérisé en ce qu'une conduite de gaz sous pression (11) est prévue comme fil (5) (supplémentaire) du câble (3).

3. Dispositif électrique suivant la revendication 1, où le câble comporte plusieurs fils conducteurs et une gaine extérieure, caractérisé en ce que les espaces entre les fils conducteurs (5) ne sont pas, ou partiellement rembourrés et les espaces non rembourrés servent de conduite de gaz sous pression (11).

4. Dispositif électrique suivant l'une des revendications 1 à 3, caractérisé en ce que l'entrée de câble (2) est munie d'une pièce de raccordement pour l'admission du gaz sous pression (12) à la face extérieure et que la pièce de raccordement pour l'admission du gaz sous pression (12) est munie d'une pièce de raccordement (13) pour une conduite de gaz sous pression externe (14).

5. Dispositif électrique suivant les revendications 2 et 4, caractérisé en ce que dans la pièce de raccordement pour l'admission du gaz sous pression (12) la conduite de gaz sous pression (11) est sortie du câble (3) et menée vers la pièce de raccordement (13).

6. Dispositif électrique suivant l'une des revendications 3 et 4, caractérisé en ce que dans la pièce de raccordement pour l'admission du gaz sous pression (12) possède un anneau (15), muni d'un canal circulant, remplaçant la gaine extérieure (4) du câble (3) sur une petite partie de la longueur du câble (3), l'anneau (15) étant relié à la pièce de raccordement (13) à l'aide d'un canal de gaz sous pression (16) et les espaces entre les fils conducteurs (5) du câble (3) étant rembourrés de façon étanche à la pression à la face extérieure de la pièce de raccordement pour l'admission du gaz sous pression (12).

7. Dispositif électrique suivant l'une des revendications 4 à 6, caractérisé en ce que la pièce de raccordement pour l'admission du gaz sous pression (12) montre une pièce intercalée (17) introduisable ou vissable, de préférence portant la pièce de raccordement (13).

8. Dispositif électrique suivant l'une des revendications 4 à 7, caractérisé en ce qu'une soupape de retenue (18) pour la conduite de gaz sous pression (11) respectivement pour le canal de gaz sous pression (16) est prévue dans la pièce de raccordement pour l'admission du gaz sous pression (12).

9. Dispositif électrique suivant l'une des revendications 7 et 8, caractérisé en ce que la soupape de retenue (18) fait partie de la pièce intercalée.

10. Dispositif électrique suivant la revendication 1, caractérisé en ce que l'entrée de câble (2) présente un canal de gaz sous pression (19) avec une bouche à la face extérieure et une bouche à la face intérieure de l'entrée de câble (2), disposé principalement en parallèle au canal servant à l'introduction du câble (3).

11. Dispositif électrique suivant la revendication 10, caractérisé en ce que le canal de gaz sous pression (19), à sa bouche disposée à la face extérieure de l'entrée de câble (2), est prévu d'une pièce de raccordement (20) pour être raccordée à une conduite de gaz sous pression externe (21).

12. Dispositif électrique suivant la revendication 10 ou 11, caractérisé en ce que la bouche disposée à la face intérieure de l'entrée de câble (2) et/ou la bouche du canal de gaz sous pression (19) disposée à la face extérieure de l'entrée de câble (2) est exécutée comme pièce intercalée (22) introduisable ou vissable dans l'entrée de câble (2).

13. Dispositif électrique suivant l'une des revendications 10 à 12, caractérisé en ce qu'une soupape de retenue (23) a été intégrée dans le canal de gaz sous pression (19).

14. Dispositif électrique suivant les revendications 12 et 13, caractérisé en ce que la soupape de retenue (23) fait partie de la pièce intercalée (22).

15. Dispositif électrique suivant l'une des revendications 1 à 14, caractérisé en ce que le raccordement pour l'admission du gaz sous pression est muni d'une soupape de protection, de préférence pouvant s'ouvrir automatiquement lors du raccordement à une conduite de gaz sous pression externe.

16. Dispositif électrique suivant l'une des revendications 1 à 15, caractérisé en ce que l'entrée de câble présente un capteur de pression à la face intérieure et au besoin une indicateur de pression à la face extérieure.

**Fig.1**

**Fig.2**

**Fig.3**

Fig.4

Fig.5

Fig.6